# EUROPÄISCHE PATENTSCHRIFT

(11) **EP 3 609 647 B1**
(45) Veröffentlichungstag und Bekanntmachung des Hinweises auf die Patenterteilung: **14.04.2021**
(21) Anmeldenummer: 18737251.1
(22) Anmeldetag: 04.07.2018
(51) Int. Cl.: B23K 1/19, B23K 35/30, B23K 35/00, B23K 35/02, C04B 37/02, C22C 9/05, C22C 9/02, C22C 9/00, B23K 1/00, B23K 103/02, B23K 103/08, B23K 103/00, B23K 103/18

(54) **LÖTMATERIAL ZUM AKTIVLÖTEN UND VERFAHREN ZUM AKTIVLÖTEN**
BRAZING MATERIAL FOR ACTIVE BRAZING AND METHOD FOR ACTIVE BRAZING
MATÉRIAU DE BRASAGE POUR BRASAGE ACTIF ET PROCÉDÉ DE BRASAGE ACTIF

(30) Priorität: 04.07.2017 DE 102017114893
(43) Veröffentlichungstag der Anmeldung: 19.02.2020
(73) Patentinhaber: Rogers Germany GmbH, 92676 Eschenbach (DE)
(72) Erfinder: BRITTING, Stefan, 91220 Schnaittach (DE); MEYER, Andreas, 93173 Wenzenbach (DE)
(74) Vertreter: Müller Schupfner & Partner Patent- und Rechtsanwaltspartnerschaft mbB
(86) Internationale Anmeldenummer: PCT/EP2018/068020
(87) Internationale Veröffentlichungsnummer: WO 2019/008003

(56) Entgegenhaltungen:
- EP-A1- 0 492 435
- EP-A2- 0 185 954
- JP-A- H04 238 877
- JP-A- 2003 283 064
- US-A- 4 426 033
- US-A- 4 603 090

## Beschreibung

Die vorliegende Erfindung betrifft ein Lötmaterial zum Aktivlöten und ein Verfahren zum Aktivlöten von elektronischen Komponenten und Bauteilen.

Lötmaterialien sind aus dem Stand der Technik hinlänglich, z.B. aus US 2014 126 155 A1, bekannt und dienen der stoffschlüssigen Verbindung von Bauteilen. Insbesondere betrifft die vorliegende Erfindung solche Lötmaterialen, die zum Aktivlöten vorgesehen sind und der Anbindung einer Metallisierung an ein Keramik umfassendes Trägersubtrat dienen. Typischerweise umfassen solche Lötmaterialien einen vergleichsweise hohen Silberanteil, wenn die Lötung bei Temperaturen von unter 1000°C erfolgen soll. Mit diesem hohen Silberanteil gehen vergleichsweise hohe Materialkosten einher. Außerdem besteht die Gefahr einer Silbermigration an den Rändern der Lötschicht an dem Keramik umfassenden Trägersubstrat, wenn elektrische Felder im Betrieb angelegt werden.

Aus der US 4 603 090 A ist eine duktile Lötfolie bekannt. Dabei kann die Lötfolie aus 0,1 - 5 Gew. % eines reaktiven Metalls aus der Gruppe Ti, V, Zr oder aus einer Mischung von Elementen aus dieser Gruppe sowie 1-30 Gew. % Indium und 55-99,8 Gew-% Kuper bestehen.

Aus der DE 10 2015 108 668 A1 ist ein Verfahren zur Herstellung einer Leiterplatte bekannt, wobei die Leiterplatte ein flächiges Basismaterial, insbesondere eine Keramik, aufweist, an welcher ein- oder beidseitig mittels einer Lotschicht eine Metallisierung angebracht wird.

Die US 4 426 033 A betrifft reaktive Metall-Kupfer-Legierung mit einer bestimmten Menge an einem dritten Metall aus der Gruppe von Silizium, Zinn, Germanium, Mangan, Nickel, Kobalt oder Mischungen daraus, wobei diese Legierung geeignet ist Keramiken zu löten.

Die US 4 784 313 A nennt ein Verfahren zum Verbinden von Formteilen aus SiC-Keramik miteinander oder mit Formteilen aus anderer Keramik oder Metall, bei dem die zu verbindenden Oberflächen unter Zwischenschaltung einer Metallschicht unter Diffusionsschweißbedingungen vereinigt werden. Dabei ist es vorgesehen, dass als Metallschicht eine Manganlegierungsschicht aus MnCu (mit 25-82 Gew.-% Cu) oder MnCo (mit 5-50 Gew.-% Co) vorgesehen wird, die ggf. zusätzlich je 2-45 Gew.-% von zumindest einem der Metalle Cr, Ti, Zr, Fe, Ni und/oder Ta aufweist, wobei die Summe der Zusätze 70 Gew.-% nicht überschreiten soll.

Die DE 698 22 533 T1 kennt darüber hinaus ein Keramikelement, das einen elektrischen Stromversorgungsanschluss aufweist, worin ein metallisches Element in das Keramikelement eingebettet ist und gegenüber einer Ausnehmung des Keramikelements teilweise frei liegt, ein röhrenförmiges Atmosphärenabschirmungselement in die Ausnehmung hinein gesetzt ist und mit dem eingebetteten metallischen Element verbunden ist.

Aus der JO 2003 283 064, der EP 0 492 435 A1 und der EP 0 185 954 A2 sind weitere Lötmaterialzusammensetzungen bekannt.

Die JP 238 877 offenbart ein Lötverfahren bei etwa 850 °C mit einem Lotmaterial, das einen Titananteil von 15 Gew.-% aufweist.

Es ist somit eine Aufgabe der vorliegenden Erfindung, ein Lötmaterial bereitzustellen, das sich im Vergleich zum Stand der Technik kostengünstig herstellen lässt und bei dem eine Silbermigration vermieden werden kann.

Diese Aufgabe wird gelöst durch ein Lötmaterial zum Aktivlöten gemäß Anspruch 1, durch eine Trägerschicht gemäß Anspruch 3 und durch ein Verfahren gemäß Anspruch 4 . Weitere Vorteile und Merkmale der Erfindung ergeben sich aus den Unteransprüchen sowie der Beschreibung und den beigefügten Figuren.

Erfindungsgemäß ist ein Lötmaterial zum Aktivlöten, insbesondere zum Aktivlöten einer Metallisierung an eine Keramik umfassende Trägerschicht, vorgesehen, wobei das Lötmaterial Kupfer umfasst und im Wesentlichen silberfrei ist.

Im Gegensatz zum Stand der Technik wird beim erfindungsgemäßen Lötmaterial mit Vorteil auf Silber verzichtet, wodurch Herstellungskosten reduziert werden können und eine Silbermigration vermieden werden kann. Dabei ist statt Silber Kuper oder eine Kupferlegierung der Hauptbestandteil des Lötmaterials. Unter "im Wesentlichen silberfrei" ist insbesondere zu verstehen, dass das Lötmaterial ein Anteil an Silber im Bereich von Verunreinigungen, d.h. von weniger als 0,5 Gew.- %, bevorzugt weniger als 0,1 Gew.-% und besonders bevorzugt weniger als 0,05 Gew. -% des Lötmaterials aufweist. Grundsätzlich lassen sich beispielsweise mittels des Lötmaterials mehrere Keramikschichten miteinander verbinden oder eine Metallisierung, bevorzugt eine Kupferschicht, an eine Keramik umfassende Trägerschicht, anbinden. Vorzugsweise ist es vorgesehen, dass die an die Trägerschicht angebundene Metallisierung strukturiert wird, insbesondere strukturiert wird, um beispielsweise Leiterbahnen oder Anschlussstellen für elektrische bzw. elektronische Bauteile auszubilden.

Vorzugsweise ist es vorgesehen, dass das Lötmaterial in einem Fertigungsschritt von Silber bzw. Silberrückständen befreit wird bzw. dessen Anteil reduziert wird. Dadurch lässt sich in vorteilhafter Weise sicherstellen, dass das Lötmaterial silberfrei ist.

Unter einem Aktivlöt-Verfahren, z. B. zum Verbinden von Metallschichten oder Metallfolien, insbesondere auch von Kupferschichten oder Kupferfolien mit Keramikmaterial, ist ein Verfahren zu verstehen, bei dem bei einer Temperatur zwischen ca. 650 - 1000 °C unter Verwendung des Lötmaterials eine Verbindung zwischen einer Metallfolie, beispielsweise einer Kupferfolie, und einem Keramiksubstrat, beispielsweise einer Aluminiumnitrid-Keramik, hergestellt wird. Dabei enthält das Lötmaterial zusätzlich zu einer Hauptkomponente Kupfer auch ein Aktivmetall. Dieses Aktivmetall, welches Ti ist, stellt durch chemische Reaktion mit der Keramik eine Verbindung zwischen dem Lötmaterial und der Keramik mittels einer Reaktionsschicht her, während die Verbindung zwischen dem Lötmaterial und dem Metall eine metallische Hartlöt-Verbindung ist.

Insbesondere ist es vorgesehen, dass die Trägerschicht Al₂O₃, Si₃N₄, AIN, BeO oder eine ZTA (Zirconia toughened Alumina) - Keramik im weiteren HPSX Keramik genannt (, d. h. einer Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25) aufweist, wobei auch Kombinationen der genannten Trägermaterialien denkbar sind.

Dabei ist vorgesehen, dass das Lötmaterial einen Kupferanteil im Wesentlichen 64, 66 bzw. 69 Gew. % aufweist. Hier ersetzt mit Vorteil der Kupferanteil den üblicherweise vergleichsweise hohen Anteil an Silber. Der Kupferanteil kann dabei abhängig von den einzelnen weiteren Bestandteilen eingestellt werden.

Es hat sich in vorteilhafter Weise herausgestellt, dass bei einer solchen Zusammensetzung ein vergleichsweise große Anzahl von verschiedenen Begleitmetalle bzw. Aktivmetalle genutzt werden kann, um ein prozesssicheres Lötmaterial (d. h. einem Lötmaterial, mit dem eine sichere und dauerhafte Verlötung realisiert werden kann) ohne Silber zu realisieren. Dies gestattet in vorteilhafter Weise eine individuelle Anpassung des Lötmaterials an den jeweiligen Anwendungsfall, ohne auf eine silberhaltige Zusammensetzung für das Lötmaterial zurückgreifen zu müssen.

In einer weiteren Ausführungsform der vorliegenden Erfindung ist es vorgesehen, dass das Lötmaterial zur Herabsetzung der Schmelztemperatur ein Begleitmaterial, wie Indium (In), Mangan (Mn) oder Zinn (Sn), aufweist. Durch das Hinzufügen der Begleitmaterialien, wie Begleitmetalle, lässt sich mit Vorteil eine Schmelztemperatur zwischen 700 - 900 °C einstellen. Die Begleitmetalle In, Mn oder Sn erweisen sich dabei als besonders vorteilhaft, weil sie sich für ein Lötprozess auch bei niedrigen Dampfdrücken, beispielsweise unterhalb von 10 ⁻³ mbar, beispielsweise beim Vakuumlöten, eignen.

In einer weiteren Ausführungsform der vorliegenden Erfindung ist es vorgesehen, dass das Begleitmaterial am Lötmaterial einen Gesamtanteil von im Wesentlichen 29, 32, 34 bzw. 39 Gew.% wie im Anspruch 1 aufweist. Die Zugabemenge des Begleitmaterials richtet sich vorzugsweise nach einer gewünschten Schmelztemperatur, die für den Lötprozess vorgesehen ist. Hierbei gilt insbesondere für In und Sn: Je mehr Begleitmaterialien desto niedriger die Schmelz- bzw. Löttemperatur. Allerdings wird die Schmelztemperaturerniedrigung dahingehend beschränkt, dass die Schmelz- bzw. Löttemperatur so hoch sein muss, dass eine chemische Reaktion zwischen dem Aktivmetall und der keramischen Oberfläche erfolgt. Typischerweise muss die Schmelztemperatur dabei oberhalb von 700 und 800 °C liegen. Mit einer Zusammensetzung, bei der der Gesamtanteil des Begleitmaterials bei im Wesentlichen 29, 32, 34 bzw. 39 Gew.% wie im Anspruch 1 liegt, lässt sich mit Vorteil ein Aktivmetall bereitstellen, bei dem einerseits die Schmelztemperaturerniedrigung ausreichend groß ist und das andererseits mit einer möglichst großen Vielzahl an verschiedenen keramischen Oberflächen kompatibel ist. Außerdem lässt sich ein Anteil an intermetallischen Phasen, die zu einer verminderten mechanischen Festigkeit der Lötverbindung führen können, reduzieren, da mit zunehmendem Anteil an Begleitmaterialien auch der Anteil von intermetallischen Phasen steigt.

Zweckmäßig ist es vorgesehen, dass das Lötmaterial als Aktivmetall Ti aufweist. Dabei ist es insbesondere vorgesehen, dass das Aktivmetall hier ein Anteil von im Wesentlichen 2 Gew.% am Lotmaterial aufweist. Der Anteil an Aktivmetall wird vorzugweise anwendungsfallabhängig, beispielsweise in Abhängigkeit von den zu fügenden Materialien, angepasst.

Insbesondere ist es vorgesehen, dass das Lötmaterial eine Paste oder eine Folie ist. Beispielsweise wird die Paste bevorzugt als Zusammensetzung aus einem Pulver, das neben Kupfer und dem Aktivmetall auch das Begleitmaterial umfasst, und organischen Stoffen bereitgestellt. Die organischen Stoffe machen die Paste mit Vorteil siebdruckfähig und aushärtbar. In einer vorteilhaften Ausführungsform ist es vorgesehen, dass das Kupfer und die Begleitmaterialien als mikrolegiertes Pulver vorliegen. Beispielsweise handelt es sich um ein mikrolegiertes Pulver, das im Rahmen eines Verdüsungsprozesses mittels einer Verdüsungsanlage entsteht. Das Aktivmetall wird vorzugsweise pulverförmig beigemischt, beispielsweis als Ti oder TiH. Zur Erhöhung einer Löslichkeit des Aktivmetalls im Lötprozess, ist es vorteilhaft vorgesehen, dass das Aktivmetall auch zusammen mit den anderen Materialien des Lötmaterials als binäre oder ternäre Legierung dem Lötmaterial pulverförmig zugefügt bzw. beigemischt ist. Für eine möglichst homogene Verteilung des Aktivmetalls, ist es denkbar, dass das Aktivmetall in das in der Verdüsungsanlage zu legierenden Pulver integriert wird. Da das Aktivmetall mit einer Wandung der Verdüsungsanlage reagiert, ist hier ein Anteil des Aktivmetalls von im Wesentlichen 2 Gew.% vorgesehen.

Sofern das Lötmaterial als Folie bereitgestellt wird, lässt sich mit Vorteil auf organische Zusatzstoffe verzichten. Zur Bildung der Lötschicht wird dabei die Folie zwischen der Metallisierung und der Trägerschicht angeordnet. Besonders bevorzugt ist hierbei ein vergleichsweise niedriger Anteil an Begleitmaterialien und Aktivmetallen im Lötmaterial.

Gemäß der vorliegenden Erfindung ist es vorgesehen, dass das Lötmaterial im Wesentlichen
- 64 Gew. -% Kupfer, 34 Gew.-% Indium und 2 Gew.-% Titan,
- 69 Gew. -% Kupfer, 13 Gew.-% Zinn, 16 Gew.-% Indium und 2 Gew.-% Titan,
- 66 Gew. -% Kupfer, 16 Gew.-% Zinn, 16 Gew.-% Mangan und 2 Gew.-% Titan,
- 66 Gew. -% Kupfer, 16 Gew.-% Indium, 16 Gew.-% Mangan und 2 Gew.-% Titan oder
- 69 Gew. -% Kupfer, 12 Gew.-% Zinn, 7 Gew.-% Mangan, 10 Gew.-% Indium und 2 Gew.-% Titan,
sowie unvermeidbare Verunreinigungen von weniger als 0,5 Gew.-% aufweist.

Ein weiterer Gegenstand der vorliegenden Erfindung ist eine Trägerschicht mit einer Metallisierung, wobei die Metallisierung über das erfindungsgemäß Lötmaterial angebunden ist. Alle für das erfindungsgemäße Lötmaterial beschriebenen Merkmale und deren Vorteile lassen sich sinngemäß ebenfalls auf die erfindungsgemäße Trägerschicht übertragen und andersherum. Vorzugsweise ist die Metallisierung, beispielsweise eine Kupfer- oder Molybdänschicht, zur Ausbildung von Leiterbahnen und Anschlusstellen für elektrische oder elektronische Bauteile, strukturiert. Die Strukturierung ist vorzugsweise durch ein Einätzen realisiert worden.

Ein weiterer Gegenstand der vorliegenden Erfindung ist ein Verfahren zum Anbinden einer Metallisierung an eine Trägerschicht, insbesondere eine Keramik umfassende Trägerschicht, wobei ein Lötmaterial gemäß einem der vorhergehenden Ansprüche verwendet wird. Alle für das erfindungsgemäße Lötmaterial beschriebenen Merkmale und deren Vorteile lassen sich sinngemäß ebenfalls auf das erfindungsgemäße Verfahren übertragen und andersherum.

Es ist vorgesehen, dass ein Anbinden bei einer Löttemperatur von weniger als 850 °C durchgeführt wird. Vorzugsweise ist das Lötmaterial entsprechend ausgelegt, beispielsweise durch Hinzugabe einer entsprechenden Menge an Aktivmetallen oder Begleitmetallen, um die gewünschte Temperatur zu realisieren. Durch das Löten bei niedrigen Temperaturen unterhalb von 850 °C, ist es möglich, den Energieaufwand beim Löten vergleichsweise gering zu halten.

Gemäß einer weiteren Ausführungsform der vorliegenden Erfindung ist es vorgesehen, dass das Lötmaterial in einem Siebdruckverfahren auf die Keramik umfassende Trägerschicht aufgetragen wird. Dadurch lässt sich das Lötmaterial in vorteilhafter Weise gleichmäßig flächig auftragen, insbesondere für die flächige Anbindung einer Metallschicht an eine Keramikschicht.

Weitere Vorteile und Merkmale ergeben sich aus der nachfolgenden Beschreibung bevorzugter Ausführungsformen des erfindungsgemäßen Gegenstands mit Bezug auf die beigefügte Figur. Einzelne Merkmale der einzelnen Ausführungsform können dabei im Rahmen der Erfindung miteinander kombiniert werden.

Es zeigt:

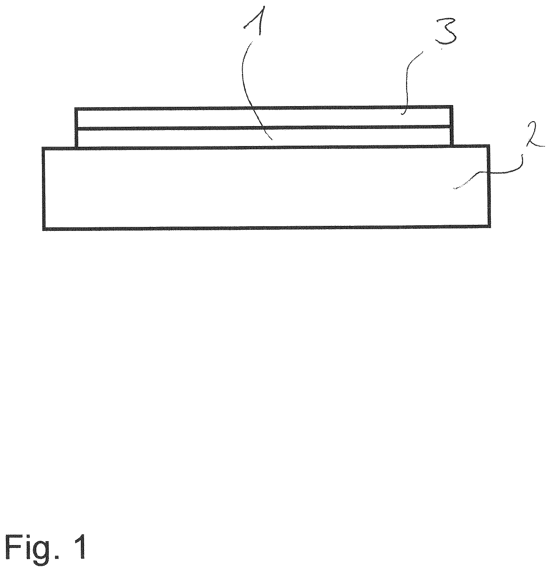

- **Fig.1:**: eine Trägerschicht mit einer Metallisierung gemäß einer beispielhaften Ausführungsform der vorliegenden Erfindung.

In **Figur 1** ist eine Trägerschicht 2 mit einer Metallisierung gemäß einer beispielhaften Ausführungsform der vorliegenden Erfindung dargestellt. Hierbei handelt es sich vorzugsweise um eine Trägerschicht 2, auf der elektronische oder elektrische Bauteile angeordnet werden. Hierfür ist eine Metallisierung 3 vorgesehen, vorzugsweise eine strukturiert Metallisierung 3, um Leiterbahnen oder Anschlussstellen für die elektrischen oder elektronischen Bauteile bereitzustellen. Die Metallisierung 3 ist vorzugsweise mittels eines Aktivlötverfahrens an die Trägerschicht 2, die insbesondere Kupfer umfasst, gebunden worden. Zur Senkung der Herstellungskosten und zur Vermeidung einer Silbermigration ist es bevorzugt vorgesehen, dass zum Aktivlöten Lötmaterial 1 verwendet wurde, das Kupfer umfasst und im Wesentlichen silberfrei ist.

Beim Aktivlöt-Verfahren wird im Allgemeinen bei einer Temperatur zwischen ca. 650-1000°C eine Verbindung zwischen einer Metallfolie, beispielsweise einer Kupferfolie, und einem Keramiksubstrat, beispielsweise einer Aluminiumnitrid-Keramik, unter Verwendung des Lötmaterials 1 hergestellt, welches zusätzlich zu einer Hauptkomponente Kupfer auch ein Aktivmetall enthält. Dieses Aktivmetall stellt durch chemische Reaktion eine Verbindung zwischen dem Lötmaterial und der Keramik her, während die Verbindung zwischen dem Lötmaterial und dem Metall eine metallische Hartlöt-Verbindung ist.

Um das Lötmaterial an die erforderlichen Schmelztemperaturen anzupassen, ist es insbesondere vorgesehen, dass das Lötmaterial 1 ein Begleitmaterial, In, Mn oder Sn, aufweist.

## Patentansprüche

1. Lötmaterial (1) zum Aktivlöten, insbesondere zum Aktivlöten einer Metallisierung (3) an eine Keramik umfassende Trägerschicht (2), wobei das Lötmaterial Kupfer umfasst und silberfrei ist, **dadurch gekennzeichnet, dass** das Lötmaterial (1) im Wesentlichen aus
- 64 Gew. -% Kupfer, 34 Gew.-% Indium und 2 Gew.-% Titan,
- 69 Gew. -% Kupfer, 13 Gew.-% Zinn, 16 Gew.-% Indium und 2 Gew.-% Titan,
- 66 Gew. -% Kupfer, 16 Gew.-% Zinn, 16 Gew.-% Mangan und 2 Gew.-% Titan,
- 66 Gew. -% Kupfer, 16 Gew.-% Indium, 16 Gew.-% Mangan und 2 Gew.-% Titan oder
- 69 Gew. -% Kupfer, 12 Gew.-% Zinn, 7 Gew.-% Mangan, 10 Gew.-% Indium und 2 Gew.-% Titan,
und ansonsten aus unvermeidbaren Verunreinigungen von weniger als 0,5 Gew.-% besteht.

2. Lötmaterial (1) gemäß Anspruch 1, wobei das Lötmaterial (1) eine Paste oder eine Folie ist.

3. Trägerschicht (2) mit einer Metallisierung (3), wobei die Metallisierung (3) über das Lötmaterial (1) gemäß einem der vorhergehenden Ansprüche an die Trägerschicht (2) angebunden ist.

4. Verfahren zum Anbinden einer Metallisierung (3) an eine Trägerschicht (2), insbesondere eine Keramik umfassende Trägerschicht (2), wobei ein Lötmaterial (1) verwendet wird, wobei das Lötmaterial im Wesentlichen
- 64 Gew.-% Kupfer, 34 Gew.-% Mangan und 2 Gew.-% Titan,
- 64 Gew. -% Kupfer, 34 Gew.-% Indium und 2 Gew.-% Titan,
- 75 Gew. -% Kupfer, 23 Gew.-% Zinn und 2 Gew.-% Titan,
- 69 Gew. -% Kupfer, 13 Gew.-% Zinn, 16 Gew.-% Indium und 2 Gew.-% Titan,
- 66 Gew. -% Kupfer, 16 Gew.-% Zinn, 16 Gew.-% Mangan und 2 Gew.-% Titan,
- 66 Gew. -% Kupfer, 16 Gew.-% Indium, 16 Gew.-% Mangan und 2 Gew.-% Titan oder
- 69 Gew. -% Kupfer, 12 Gew.-% Zinn, 7 Gew.-% Mangan, 10 Gew.-% Indium und 2 Gew.-% Titan, ansonsten aus unvermeidbaren Verunreinigungen von weniger als 0,5 Gew.-% besteht, wobei eine Anbindung bei einer Löttemperatur von weniger als 850 °C durchgeführt wird.

5. Verfahren gemäß dem Anspruch 4, wobei das Lötmaterial (1) in einem Siebdruckverfahren auf die Keramik umfassende Trägerschicht (2) aufgetragen wird.

## Claims

1. A brazing material (1) for active brazing, especially for active brazing a metallization (3) to a ceramic-comprising support layer (2), the brazing material comprising copper and being silver-free, **characterized in that** the brazing material (1) essentially consists of,
- 64 wt.% copper, 34 wt.% indium and 2 wt.% titanium,
- 69 wt% copper, 13 wt% tin, 16 wt% indium and 2 wt% titanium,
- 66 wt% copper, 16 wt% tin, 16 wt% manganese, and 2 wt% titanium,
- 66 wt.% copper, 16 wt.% indium, 16 wt.% manganese and 2 wt.% titanium or
- 69 wt.% copper, 12 wt.% tin, 7 wt.% manganese, 10 wt.% indium and 2 wt.% titanium,
with the balance consisting of inevitable impurities of less than 0.5 wt.%.

2. The brazing material (1) according to claim 1, wherein the brazing material (1) is a paste or a foil.

3. A support layer (2) comprising a metallization (3), wherein the metallization (3) is bonded to the support layer (2) via the brazing material (1) of one of the preceding claims.

4. A method for bonding a metallization (3) to a support layer (2), especially a ceramic-comprising support layer (2), wherein a brazing material (1) is used, said brazing material essentially consisting of
- 64 wt.% copper, 34 wt.% manganese and 2 wt.% titanium,
- 64 wt% copper, 34 wt% indium and 2 wt% titanium,
- 75 wt% copper, 23 wt% tin and 2 wt% titanium,
- 69 wt% copper, 13 wt% tin, 16 wt% indium and 2 wt% titanium,
- 66 wt% copper, 16 wt% tin, 16 wt% manganese, and 2 wt% titanium,
- 66 wt.% copper, 16 wt.% indium, 16 wt.% manganese and 2 wt.% titanium or
- -69 wt.% copper, 12 wt.% tin, 7 wt.% manganese, 10 wt.% indium and 2 wt.% titanium,
with the balance consisting of inevitable impurities of less than 0.5 wt.%, wherein bonding is performed at a brazing temperature of less than 850 °C.

5. The method according to claim 4, wherein the brazing material (1) is applied to the ceramic-comprising support layer (2) by a screen printing process.

## Revendications

1. Matériau de brasage (1) pour le brasage actif, en particulier pour le brasage actif d'une métallisation (3) sur une couche de support (2) contenant de la céramique, le matériau de brasage contenant du cuivre et étant exempt d'argent, **caractérisé en ce que** le matériau de brasage (1) est constitué sensiblement de
- 64 % en poids de cuivre, 34 % en poids d'indium et 2 % en poids de titane,
- 69 % en poids de cuivre, 13 % en poids d'étain, 16 % en poids d'indium et 2 % en poids de titane,
- 66 % en poids de cuivre, 16 % en poids d'étain, 16 % en poids de manganèse et 2 % en poids de titane,
- 66 % en poids de cuivre, 16 % en poids d'indium, 16 % en poids de manganèse et 2 % en poids de titane, ou
- 69 % en poids de cuivre, 12 % en poids d'étain, 7 % en poids de manganèse, 10 % en poids d'indium et 2 % en poids de titane,
le reste étant des impuretés inévitables de moins de 0,5 % en poids.

2. Matériau de brasage (1) selon la revendication 1, le matériau de brasage (1) étant une pâte ou une feuille.

3. Couche de support (2) ayant une métallisation (3), la métallisation (3) étant liée à la couche de support (2) par l'intermédiaire du matériau de brasage selon l'une des revendications précédentes.

4. Procédé pour lier une métallisation (3) à une couche de support (2), en particulier à une couche de support (2) contenant de la céramique, en utilisant un matériau de brasage (1), le matériau de brasage étant constitué sensiblement de
- 64 % en poids de cuivre, 34 % en poids de manganèse et 2 % en poids de titane,
- 64 % en poids de cuivre, 34 % en poids d'indium et 2 % en poids de titane,
- 75 % en poids de cuivre, 23 % en poids d'étain et 2 % en poids de titane,
- 69 % en poids de cuivre, 13 % en poids d'étain, 16 % en poids d'indium et 2 % en poids de titane,
- 66 % en poids de cuivre, 16 % en poids d'étain, 16 % en poids de manganèse et 2 % en poids de titane,
- 66 % en poids de cuivre, 16 % en poids d'indium, 16 % en poids de manganèse et 2 % en poids de titane, ou
- 69 % en poids de cuivre, 12 % en poids d'étain, 7 % en poids de manganèse, 10 % en poids d'indium et 2 % en poids de titane,
le reste étant des impuretés inévitables de moins de 0,5 % en poids,
une liaison ayant lieu à une température de brasage de moins de 850 °C.

5. Procédé selon la revendication 4, dans lequel le matériau de brasage (1) est déposé sur la couche de support (2) contenant de la céramique par un procédé de sérigraphie.
